(19) **Europäisches Patentamt / European Patent Office / Office européen des brevets**

(11) **EP 1 630 730 B1**

(12) **EUROPÄISCHE PATENTSCHRIFT**

(45) Veröffentlichungstag und Bekanntmachung des Hinweises auf die Patenterteilung:
**10.09.2008 Patentblatt 2008/37**

(51) Int Cl.:
*G06K 19/077* (2006.01)　　*G06K 19/07* (2006.01)

(21) Anmeldenummer: **05017952.2**

(22) Anmeldetag: **18.08.2005**

(54) **Transponder**

Transponder

Transpondeur

(84) Benannte Vertragsstaaten:
**AT BE BG CH CY CZ DE DK EE ES FI FR GB GR HU IE IS IT LI LT LU LV MC NL PL PT RO SE SI SK TR**

(30) Priorität: **27.08.2004 DE 102004041644**

(43) Veröffentlichungstag der Anmeldung:
**01.03.2006 Patentblatt 2006/09**

(73) Patentinhaber: **Giesecke & Devrient GmbH 81677 München (DE)**

(72) Erfinder:
- **Finkenzeller, Klaus 85774 Unterföhring (DE)**
- **Ojster, Albert 81337 München (DE)**

(74) Vertreter: **Klunker . Schmitt-Nilson . Hirsch Winzererstrasse 106 80797 München (DE)**

(56) Entgegenhaltungen:
**GB-A- 2 393 076　　US-A- 5 552 790 US-B1- 6 329 915**

**Beschreibung**

Die vorliegende Erfindung betrifft einen Transponder mit Patch-Antenne und ein System mit einem solchen Transponder. Die Erfindung betrifft des weiteren ein Verfahren zur Herstellung des Transponders und des Systems.

Patch-Antennen sind flächige Antenneneinrichtungen. Sie sind daher geeignet zur Applikation auf den unterschiedlichsten Gegenständen. In ihrer einfachsten Form besteht eine Patch-Antenne aus einer beidseitig metallisierten Leiterplatte, bei der die Unterseite eine Massefläche bildet, während die Oberseite in ihren geometrischen Abmessungen als Planar-Antenne ausgebildet ist. Häufig werden Patch-Antennen im Zusammenhang mit Transpondern eingesetzt und auf einen Untergrund aufgeklebt, um dadurch den Transponder einschließlich der Patch-Antenne dauerhaft mit dem entsprechenden Gegenstand zu verbinden. Auch die Versorgung des in dem Transponder enthaltenen Transponderchips kann über die Antenne erfolgen.

Transponder mit Patch-Antenne werden auch in RFID-Systemen (Radio-Frequency-Identification) verwendet, bei denen die Identifikation des Transponders bzw. eines mit dem Transponder versehenen Gegenstand durch Radiowellen erfolgt. Die Grundlagen von RFID-Systemen sind in Finkenzeller, "RFID-Handbuch", 3. Aufl., Carl Hanser Verlag, München erläutert.

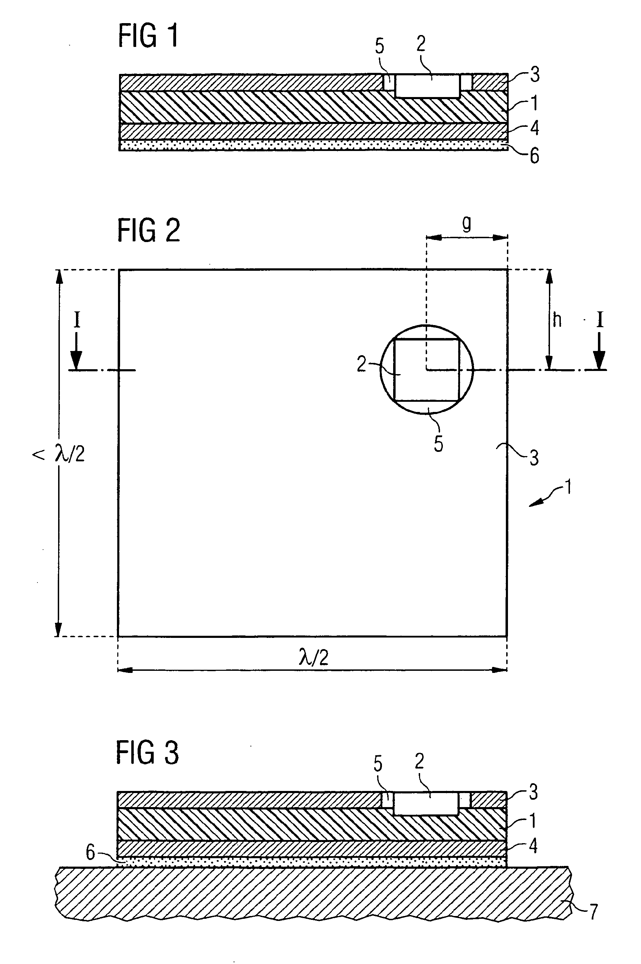

Für die Performance einer Patch-Antenne hat es sich als bedeutsam erwiesen, die Abmessungen der Massefläche abhängig von der Wellenlänge der Arbeitsfrequenz zu wählen, mit der der Transponderchip betrieben wird. Im Falle einer viereckigen Antennenfläche, die entsprechend der Arbeitsfrequenz des Transponderchips etwa $\lambda/2 \times \lambda/2$ beträgt, sollte die Massefläche zumindest die Abmessungen $\lambda x \lambda$ besitzen, also mindestens die vierfache Fläche der Antennenfläche. Aus der US 6,121,878 (Figuren 10, 11) sind beispielsweise Patch-Antennen mit großen Masseflächen gezeigt, auch wenn sie in den dort dargestellten Ausführungsbeispielen noch nicht die idealen Abmessungen von $\lambda x \lambda$ besitzen. In US 6,215,402 sind verschiedene Ausführungsbeispiele von Patch-Antennen mit unterschiedlichsten Geometrien der Antennenfläche beschrieben, wobei die Größe der Massefläche weit mehr als das Vierfache der Antennenfläche beträgt (Figur 3).

Nachteilhaft an den bekannten Patch-Antennen sind die großen Abmessungen und der dadurch verursachte Material- und Handhabungsaufwand. Denn die Notwendigkeit, die Massenflächen mit Seitenabmessungen bereitzustellen, die jeweils größer als die Wellenlänge der Arbeitsfrequenz sind, bedingt vor allem bei niedrigen Radiofrequenzbereichen im Megahertzbereich um 868 MHz bis 960 MHz und darunter sehr große Masseflächen von über 30 cm x 30 cm.

GB 2 393 076 A zeigt eine (nicht wesentlich) größere Massefläche für einen Transponder, die elektrisch von der Patchantenne isoliert ist.

US 6,329,915 B1 schlägt die Verwendung eines mit der Antenne wechselwirkenden Bereiches mit hoher Dielektrizitätskonstante vor, um die Größe eines Transponders zu reduzieren. Eine separate, zwischen einem Chip und einer Antennenfläche angeordnete Massefläche des Transponders ist so groß, wie die Antennenfläche.

Gemäß US 5,552,790, A1 wird ein Transponder mit Patchantenne so in einer metallischen Aufnahme angeordnet, dass die Reflektion von Signalen an der Aufnahme die Signalqualität verbessert. Die zwei Flächen der Patchantenne sind gleich groß, so dass der Transponder in beliebiger Orientierung in die Aufnahme einsetzbar ist.

Es ist die Aufgabe der Erfindung, einen hinsichtlich Herstellungskosten optimierten Transponder bereit zu stellen. Diese Aufgabe wird jeweils gelöst durch den Gegenstand der unabhängigen Ansprüche.

Der erfindungsgemäße Transponder ist mit einer Patch-Antenne ohne (ausreichende) eigene Massefläche ausgebildet. Vielmehr wird der Transponder auf einem metallischen, gegebenenfalls auch lackierten Bestandteil des mit dem Transponder auszustattenden Gegenstandes appliziert. Dabei kann es sich beispielsweise um das Blech einer Fahrzeugkarosserie handeln. Dieser metallische Bestandteil des Gegenstands, d. h. das Blech der Fahrzeugkarosserie, bildet dann die (eigentliche) Massefläche für die Patch-Antenne des Transponders.

Auf diese Weise kann sowohl Material eingespart als auch die Baugröße der Patch-Antenne und damit eines RFID-Transponders wesentlich reduziert werden, insbesondere wenn der Transponder für den Betrieb im 868 MHz-Frequenzbereich oder darunter eingerichtet ist. Einsatzmöglichkeiten ergeben sich beispielsweise in der Autoindustrie zur Identifikation von Karosserieteilen in einer Fertigungsstraße. Ein besonderer Vorteil der erfindungsgemäßen Transponder besteht in seinen guten Leistungsergebnissen (große Lesereichweite, keine "Verstimmung" durch die Metalloberfläche, etc.) sowie der Möglichkeit, die Transponder nach der Fertigung an den Karosserieteilen verbleiben zu lassen. Auch ein Überlackieren der erfindungsgemäßen Transponder ist möglich, so dass diese später nicht als Fremdkörper am Fahrzeug wahrnehmbar sind.

Ein erfindungsgemäßer Transponder mit Patch-Antenne besitzt in herkömmlicher Weise eine elektrisch isolierende Schicht zwischen einer ersten Metallfläche und einer zweiten Metallfläche und einen Transponderchip, der mit der ersten und mit der zweiten Metallfläche elektrisch verbunden ist. Dabei ist zumindest eine der beiden Metallflächen geometrisch so ausgebildet, dass sie in der Patch-Antenne Antennenfunktion übernehmen kann, während die andere Metallfläche erfindungsgemäß geometrisch so ausgebildet ist, dass sie selbst keine ausreichende Massefläche für den bestimmungsgemäßen Betrieb der Patch-Antenne besitzt. Die zweite Metallfläche dient vielmehr im wesentlichen zur Herstellung einer elektrischen Verbindung mit dem metallischen Bestandteil des Gegenstandes, auf den der Transponder appliziert wird und der die eigentliche Massefläche bildet. Sie kann daher sehr klein sein, und ihre "Fläche" ist im Gegensatz zum Stand der Technik kleiner oder gleich der "Fläche" der die Antennenfunktion übernehmenden Metallfläche. Der Begriff "Fläche" bedeutet in diesem Zusammenhang jeweils die durch die Randkonturen der Metallflächen jeweils definierten Flächen, da die Metallflächen selbst Aussparungen aufweisen können - z. B. zur Applikation des Transponderchips - die bei dieser Flächenbetrachtung unberücksichtigt bleiben können.

Gemäß einer besonders bevorzugten Ausführungsform sind die beiden Metallflächen geometrisch jeweils so ausgebildet, dass jede der Metallflächen dieselbe Antennenfunktion der Patch-Antenne übernehmen kann. Der besondere Vorteil dieser Anordnung besteht darin, dass die Patch-Antenne in einer beliebigen Lage auf dem Gegenstand aufgebracht werden kann, da die jeweils außen liegende Metallfläche die Antennenfunktion übernimmt.

Besonders bevorzugt ist es, wenn die Randkonturen der beiden Metallflächen relativ zur Isolierschicht deckungsgleich übereinander angeordnet sind. Denn dann können die Abmessungen des gesamten Transponders auf die für die Antennenfunktion notwendige Randkontur der Patch-Antenne beschränkt sein.

Vorzugsweise ist der Transponder als Label ausgebildet, um ihn in unkomplizierter Weise handhaben und auf den Gegenstand aufbringen zu können. Zu diesem Zweck wird die Isolierschicht vorzugsweise durch eine flexible Kunststofffolie gebildet, beispielsweise aus PET, Kapton oder Teflon mit einer Dicke zwischen 10 $\mu$m und 250 $\mu$m, vorzugsweise von etwa 100 $\mu$m. Bei Verwendung von gedünnten Chips kann die Gesamtdicke des Transponders besonders gering gehalten werden, wenn der Transponderchip gemäß einer bevorzugten Ausführungsform der Erfindung in eine Vertiefung der Isolierschicht, die in besonders einfacher Weise beispielsweise in einem Prägeprozeß erzeugt werden kann, eingesetzt wird.

Der Chip kann in der Vertiefung mit einer Kunststoffmasse vergossen werden und/ oder mit einer Folie abgedeckt werden, um den Chip gegen äußere Einflüsse zu schützen. Dies ist insbesondere von Bedeutung, wenn der Chip nach der Applikation des Transponders auf den Gegenstand außenseitig zu liegen kommt. Ein Chipverguß und/ oder eine Schutzfolie zum Schutz des Transponderchips sind natürlich genauso von Vorteil, wenn der Chip nicht in einer Vertiefung der Isolierschicht sondern auf einer äußeren Oberfläche des Transponders angeordnet ist.

Der Transponderchip wird sowohl mit der Metallfläche auf der Seite, auf der der Transponderchip selbst angeordnet ist, als auch mit der auf der gegenüberliegenden Seite der Isolierschicht angeordneten Metallfläche elektrisch verbunden. Die elektrische Verbindung erfolgt vorzugsweise kontaktbehaftet mittels Leitungen durch die Isolierschicht hindurch ("Durchkontaktierung") oder ggf. auch an einer Seite über eine Mikro-Streifenleitung. Auch eine kapazitive Kopplung ist möglich.

Welche der beiden Metallflächen letztendlich Antennenfunktion übernimmt, hängt davon ab, mit welcher seiner Oberflächen der Transponder auf den Gegenstand appliziert wird. Zum Schutz des Transponderchips ist es bevorzugt, den Transponder so auf den Gegenstand zu applizieren, dass der Transponderchip auf der Innenseite des Transponders, also zwischen dem Gegenstand und der Isolierschicht des Transponders, liegt.

Der Transponder ist vorzugsweise mit einer Klebeschicht versehen, mittels der der Transponder am Gegenstand befestigt werden kann. Um die Lagerung und Handhabung des Transponders zu vereinfachen, ist die Klebeschicht vorteilhafterweise durch eine abziehbare Abdeckfolie abgedeckt.

Ein einfacher und dünner Schichtaufbau kann erreicht werden, wenn die Klebeschicht unmittelbar an eine der beiden Metallflächen angrenzt. Sie besteht vorteilhafterweise aus einem leitfähigen Kleber, wenn der Transponder mittels der Klebeschicht unmittelbar auf einer metallischen Fläche des Gegenstands appliziert wird, so dass eine galvanische Kontaktierung zwischen der betreffenden Metallfläche und dem die Massefläche für die Patch-Antenne bildenden metallischen Bestandteil des Gegenstands realisiert wird.

Auch eine kapazitive Kontaktierung einer der beiden Metallflächen mit der metallischen Komponente des Gegenstands ist möglich, wenn nämlich der Transponder auf eine nicht leitende, z. B. lackierte Metalloberfläche aufgebracht wird.

Nachfolgend wird die Erfindung beispielhaft anhand der begleitenden Zeichnungen erläutert. Darin zeigen:

Figur 1     den prinzipiellen Aufbau eines erfindungsgemäßen Transponders mit Patch-Antenne im Querschnitt,

Figur 2     den Transponder aus Figur 1 in Draufsicht,

Figur 3     den Transponder aus Figur 1 appliziert auf ein metallisches Substrat,

Figur 4     einen auf ein metallisches Substrat applizierten Transponder mit im Vergleich zu Figur 3 umgekehrter Schichtreihenfolge,

Figur 5     die Anordnung gemäß Figur 4, wobei das metallische Substrat elektrisch isolierend beschichtet ist,

Figur 6     den Aufbau gemäß Figur 3 mit einer äußeren Transponderschutzfolie,

Figur 7    den Aufbau gemäß Figur 3 mit einem vollflächigen Lacküberzug,

Figur 8    eine Metallfolie mit Aussparung für den Transponder und

Figur 9    den prinzipiellen Aufbau eines erfindungsgemäßen Transponders im Querschnitt im weiteren Detail.

Figuren 1 und 2 zeigen den prinzipiellen Aufbau eines erfindungsgemäßen Transponders. Die Abmessungen und die dargestellten Verhältnisse sind zum Zwecke der besseren Anschaulichkeit nicht realistisch wiedergegeben.

Der Transponder besteht hier aus einer viereckig zugeschnittenen Kunststofffolie 1 und einem Transponderchip 2. Die Kunststofffolie 1 ist vorderseitig und rückseitig im wesentlichen ganzflächig jeweils mit einer Metallfläche 3, 4 beschichtet. Eine Längsseite der Metallflächen besitzt die Länge $\lambda/2$, bezogen auf die Arbeitsfrequenz des Transponderchips 2. Die Breitseite des Transponders ist ungleich $\lambda/2$ und hier kleiner als $\lambda/2$ gewählt. Die Länge der Breitseite bestimmt den Strahlungswiderstand der Patch-Antenne und kann so variiert werden, dass der Transponderchip wahlweise im Leistungs- oder Spannungsanpassung betrieben werden kann. Es sind grundsätzlich auch andere Antennengeometrien möglich, wie z. B. in US 6, 215, 401 B1 beschrieben.

Tatsächlich wird die Längsseite der Metallflächen nicht exakt als $\lambda/2$ gewählt. Wie in Finkenzeller, "RFID-Handbuch", 3. Aufl. Carl Hanser Verlag, München erläutert, beträgt die Resonanzfrequenz der Antenne definierende Seitenlänge Lp des Antennen-Patches näherungsweise

$$L_p = \lambda/2 - h_D,$$

wobei $h_D$ die Dicke des Dielektrikums, d. h. im vorliegenden Falle die Dicke der Isolierschicht (1), angibt. Da die vorliegende Erfindung aber besondere Bedeutung für Frequenzen im Megahertzbereich 868 besitzt, ist die Dicke $h_D$ der Isolierschicht im Vergleich zur Wellenlänge $\lambda$ vernachlässigbar klein, so dass die Seitenlänge der Metallfläche hier näherungsweise mit $\lambda/2$ bezeichnet werden kann.

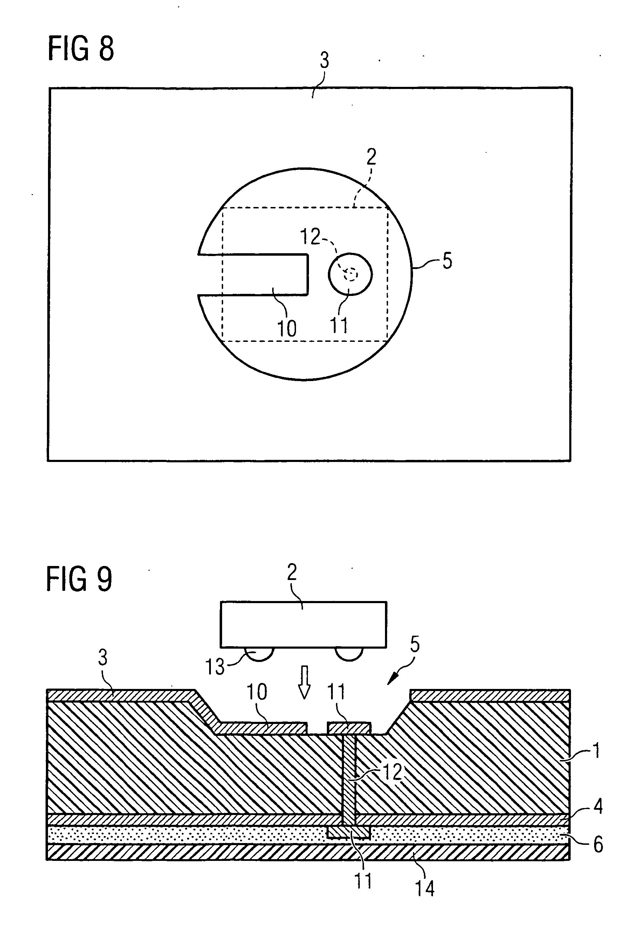

Der Chip 2 sitzt in einer Aussparung 5 der Metallfläche 3 und ist mit den beiden Metallflächen 3, 4 elektrisch verbunden (nur in Fig. 9 dargestellt). Eine der beiden Metallflächen, in Figuren 1 und 2 die dem Transponderchip 2 gegenüber liegende Metallfläche 4, ist mit einer Klebeschicht 6 beschichtet. Die Klebeschicht 6 kann aber auch auf der gleichen Seite wie der Transponderchip 2 angebracht sein. Die Klebeschicht 6 kann des weiteren mit einer abziehbaren Abdeckfolie (in Fig. 9: "Abdeckfolie 14") versehen werden.

Figur 3 zeigt den Transponder aus Figur 1 appliziert auf einem metallischen Substrat 7, beispielsweise der unlackierten Oberfläche eines Fahrzeugkarosserieblechs. In diesem Falle besteht die Klebeschicht 6 aus einem elektrisch leitenden Kleber, um einen galvanischen Kontakt zwischen der innen liegenden Metallfläche 4 des Transponders und dem metallischen Substrat 7 herzustellen. Die gegenüber liebende Metallfläche 3 übernimmt dabei automatisch die Antennenfunktion des Transponders, während das metallische Substrat 7 die Funktion einer Massefläche für die Patch-Antenne übernimmt.

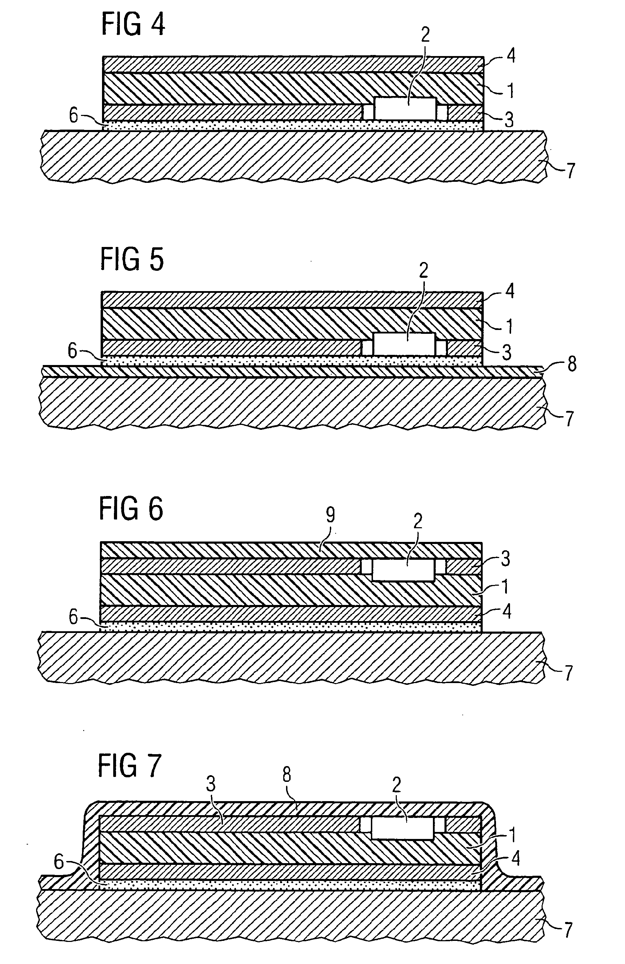

Der Transponder gemäß Figuren 1 und 2 ist insofern symmetrisch, als beide Metallflächen 3, 4 geometrisch so aufgebaut sind, dass eine jede Metallfläche die Aufgabe der Antennenfunktion des Transponders übernehmen könnte, d. h. als strahlendes Element wirken könnte, je nach dem ob der Transponder mit seiner chipseitigen Oberfläche - wie in Figur 4 gezeigt - oder mit seiner gegenüberliegenden Oberfläche - wie in Figur 3 gezeigt - auf das metallische Substrat 7 appliziert wird. Für den Fall, dass der Chip 2 auf der dem metallischen Substrat 7 zugewandten Seite des Transponders liegt, ist die Klebeschicht 6 selbstverständlich auf der chipseitigen Oberfläche des Transponders vorgesehen (Figur 4).

Figur 5 zeigt ein abgewandeltes Ausführungsbeispiel, bei dem der Transponder nicht unmittelbar auf dem metallischen Substrat sondern auf einer elektrisch isolierenden Beschichtung 8, beispielsweise einer Lackschicht, des metallischen Substrats 7 appliziert ist. In diesem Falle bildet sich eine Kapazität zwischen der Metallfläche 3 und dem metallischen Substrat 7 aus. Das metallische Substrat 7 übernimmt auch hier die Funktion einer Massefläche für die Patch-Antenne des Transponders.

Zu beachten ist jedoch bei dem Ausführungsbeispiel gemäß Figur 5, dass sich durch den Einfluß der Kapazität die hochfrequenten Eigenschaften der als Antenne wirkenden Metallfläche 4 gegenüber dem als Massefläche wirkenden metallischen Substrat 7 verändern können, wodurch gegebenenfalls die in Figur 2 gezeigten Seitenabmessungen des Transponders eine andere geometrische Dimensionierung erfordern.

Die Dimensionierung der Außenabmessungen des erfindungsgemäßen Transponders ist wesentlich für die elektrischen Eigenschaften der Patch-Antenne. In der Regel entspricht die Längsseitenlänge der die Antennenfunktion übernehmenden Metallfläche der halben Wellenlängen der Arbeitsfrequenz (bei 868 MHz: 17,3 cm; bei 915 MHz: 16,4 cm; bei 2,45 GHz: 6,1 cm). Somit führt bereits ein Frequenzbereich $\leq$ 2,45 GHz zu sehr großen Labelabmessungen. Die Länge der Breitseite kann dagegen kleiner oder auch größer als die halbe Wellenlänge der Arbeitsfrequenz dimensioniert werden und beeinflusst z. B. den Strahlungswiderstand der Patch-Antenne. Berechnungsgrundlagen dafür sind dem Fachmann bekannt und beispielsweise in Finkenzeller, "RFID-Handbuch", Carl Hanser Verlag, München erläutert.

Zur Optimierung des Verhaltens des Transponders wird die Eingangsimpedanz der Patchantenne mit der Eingangsimpedanz des Transponderchips 2 abgestimmt. Die Eingangsimpedanz ("Fußpunktwiderstand") der Patchantenne kann über die Abstände g, h des Anschlusspunktes ("Speisepunkt") des Transponderchips 2 zu der die Antennenfunktion übernehmenden Metallfläche in einem weiten Bereich gewählt werden (Figur 2). Durch geeignete Auswahl der Lage des Speisepunktes und der Variation des Strahlungswiderstands über die geometrische Abmessung der Breitseite der Patch-Antenne können die elektrischen Eigenschaften des Transponders, insbesondere die Lesereichweite, optimiert werden.

Figur 6 und 7 zeigen zwei Weiterbildungen der Erfindung ausgehend von dem Ausführungsbeispiel nach Figur 3, wobei im Falle der Figur 5 eine zusätzliche Schutzfolie 9 den Transponder außenseitig abdeckt, um den Transponderchip 2 vor äußeren Einflüssen zu schützen. Statt dessen oder zusätzlich kann der Transponderchip 2 in einer Vergussmasse vergossen sein. Figur 7 zeigt eine Weiterbildung, wonach der Transponderchip unter einer Beschichtung 8 des metallischen Substrats 7 liegt. Beispielsweise kann der Transponder auf ein Blech einer Fahrzeugkarosserie appliziert werden, noch bevor das Blech selbst mit der Lackschicht 8 lackiert wird. Der Transponder wird dann nicht mehr als Fremdkörper am Kraftfahrzeug wahrgenommen. Die Stelle des Substrats 7, an der der Transponder appliziert wird, kann zusätzlich geringfügig tiefgezogen sein, um eine Vertiefung für den Transponder zu schaffen, so dass die in Figur 7 überdimensioniert dargestellte Wölbung der Lackschicht 8 im Bereich des Transponders entfällt.

Nachfolgend wird anhand der Figuren 8 und 9 beispielhaft erläutert, wie der Transponder hergestellt werden kann.

Zunächst wird eine flexible Folie, beispielsweise eine PET-Folie, mit einer Dicke von beispielsweise 100 μm zur Verfügung gestellt und auf beiden Seiten ganzflächig mit einer Metallfläche, z. B. Kupfer, beschichtet. In einem weiteren Herstellungsschritt wird aus der Metallschicht 3 ein Bereich 5 entfernt, in dem später der Transponderchip 2 aufgenommen wird. Erfolgt die Beschichtung mit den Metallflächen 3, 4 in einem Aufdampfprozeß, so kann die Aussparung in herkömmlicher Weise in einem anschließenden Ätzprozeß erzeugt werden. Erfolgt die Beschichtung mit den Metallflächen 3, 4 dagegen durch Auflaminieren von Metallfolien, so kann die Aussparung 5 zuvor in einer der Metallfolien erzeugt werden.

Bei der Erzeugung der Aussparung im Ätzprozeß bleiben ein Steg 10 und ein Kontaktierpad 11 sowie die umgebende Metallfläche 3 stehen. Wird dagegen die Aussparung z. B. durch kreisförmige Ausstanzung in einer Metallfolie erzeugt, so können in einem folgenden Arbeitsschritt der Steg 10 sowie das Kontaktierpad 11 durch ein zusätzliches Verfahren, insbesondere durch Verdrucken mit leitfähiger Druckfarbe, aufgedruckt werden.

Als optionaler Herstellungsschritt kann im ausgesparten Bereich 5 eine Vertiefung in die Folie 1 eingeprägt werden, in welche dann der Transponderchip 2 eingesetzt wird, wodurch dieser gegen mechanische Einflüsse von außen geschützt liegt.

In einem weiteren Herstellungsschritt wird eine Durchkontaktierung zwischen den beiden Metallflächen 3, 4 hergestellt. Hierzu wird zunächst ein kleines Loch 12, das sogenannte "Via-Hole", durch Bohrung, Stanzung oder Laserung erzeugt. Je nach Art der Locherzeugung findet dieser Vorgang vor oder nach dem Beschichten der Folie mit den Metallflächen 3, 4 statt. Das Via-Hole 12 wird mit einer leitfähigen Substanz aufgefüllt, um so eine galvanisch leitfähige Verbindung zwischen dem Kontaktierpad 11 und der rückseitigen Metallfläche 4 herzustellen. Derartige Verfahren zur Herstellung einer Durchkontaktierung sind dem Fachmann beispielsweise aus der Herstellung mehrlagiger Leiterplatten in der Elektronikindustrie hinreichend bekannt.

In einem weiteren Herstellungsschritt wird der Transponderchip 2 z. B. als gedünnter Chip aufgebracht und mittels so genannter "Bumps" 13 in der Flip-Chip-Technologie mit dem Kontaktierpad 11 sowie dem Steg 10 galvanisch verbunden.

Schließlich wird in einem letzten Verfahrensschritt noch die Klebeschicht 6 auf eine der beiden Metallflächen 3, 4, hier auf die Metallfläche 4, aufgebracht. Dazu wird ein leitfähiger Klebstoff verwendet, wenn der Transponder später auf eine leitende Metalloberfläche aufgeklebt werden soll. Außerdem kann optional eine abziehbare Abdeckfolie 14 zur Abdeckung der Klebeschicht 4 aufgebracht werden. Darüber hinaus ist es für den dargestellten Fall, bei dem die Klebeschicht 4 auf der dem Transponderchip 2 gegenüberliegenden Metallfläche 4 aufgebracht wird, sinnvoll, eine separate Schutzschicht über dem Transponderchip 2 vorzusehen. Möglichkeiten zum Schutz des Transponderchip 2 bestehen z. B. in der Aufbringung einer kleinen Klebeetikette über dem Transponderchip 2, dem Einbringen des Transponderchips 2 in eine Vergussmasse oder dem Auflaminieren einer Schutzfolie 9, wie in Fig. 6 gezeigt, die sich vorzugsweise über die gesamte Metallfläche 3 erstreckt.

## Patentansprüche

1. System umfassend einen Transponder mit Patch-Antenne (1, 3, 4) und einen Gegenstand, der zumindest einen metallischen Bestandteil (7) besitzt, der Transponder umfasst

   - eine erste Metallfläche (3) mit einer ersten Randkontur,
   - eine zweite Metallfläche (4) mit einer zweiten Randkontur,

- eine zwischen der ersten Metallfläche (3) und der zweiten Metallfläche (4) angeordnete Isolierschicht (1) zur elektrischen Isolierung der ersten Metallfläche (3) gegenüber der zweiten Metallfläche (4), und
- einen Transponderchip (2), der mit der ersten Metallfläche (3) elektrisch verbunden ist,

wobei die erste Metallfläche (3) geometrisch so ausgebildet ist, dass sie für die Patch-Antenne Antennenfunktion im Radiofrequenzbereich übernehmen kann,

**dadurch gekennzeichnet,**

**dass** die durch die zweite Randkontur der zweiten Metallfläche (4) definierte Fläche kleiner ist, als die durch die erste Randkontur der ersten Metallfläche (3) definierte Fläche,

**dass** der Transponderchip (2) mit der zweiten Metallfläche (4) elektrisch verbunden ist,

**dass** die zweite Metallfläche (4) mit dem metallischen Bestandteil (7) des Gegenstands galvanisch gekoppelt ist und

**dass** der metallische Bestandteil (7) eine derartige flächenmäßige Ausdehnung besitzt und der Transponder relativ zu dem metallischen Bestandteil (7) des Gegenstands so angeordnet ist, dass der metallische Bestandteil (7) als Massefläche der Patch-Antenne wirkt.

2. System nach Anspruch 1, **dadurch gekennzeichnet, dass** der Transponderchip (2) mit der ersten Metallfläche (3) und der zweiten Metallfläche (4) galvanisch verbunden ist, insbesondere in Flip-Chip-Technologie.

3. System nach einem der Ansprüche.1 oder 2, **gekennzeichnet durch** eine Durchkontaktierung (12) **durch** die Isolierschicht (1) hindurch zur Kontaktierung des Transponderchips (2) mit der auf der dem Transponderchip (2) gegenüberliegenden Seite des Transponders liegenden ersten bzw. zweiten Metallfläche (3, 4).

4. System nach einem der Ansprüche 1 bis 3, **dadurch gekennzeichnet, dass** der Transponderchip (2) in einer Vertiefung der Isolierschicht (1) angeordnet ist.

5. System nach einem der Ansprüche 1 bis 4, **dadurch gekennzeichnet, dass** der Transponderchip (2) mittels einer separaten Schutzschicht (9) abgedeckt ist.

6. System nach Anspruch 5, **dadurch gekennzeichnet, dass** der Transponderchip (2) mittels einer Vergussmasse abgedeckt ist.

7. System nach Anspruch 5 oder 6, **dadurch gekenn-** **zeichnet, dass** der Transponderchip (2) durch eine Schutzfolie (9) abgedeckt ist, die sich über die gesamte Oberfläche des Transponders erstreckt.

8. System nach einem der Ansprüche 1 bis 7, **dadurch gekennzeichnet, dass** die Isolierschicht (1) durch eine Kunststofffolie, insbesondere aus PET und/ oder mit einer Dicke von 100 $\mu$m, gebildet ist.

9. System nach einem der Ansprüche 1 bis 8, **gekennzeichnet durch** eine Klebeschicht (6) zur Applikation des Transponders auf einem Gegenstand.

10. System nach Anspruch 9, **dadurch gekennzeichnet, dass** die Klebeschicht (6) einen leitfähigen Kleber umfasst.

11. System nach Anspruch 9 oder 10, **dadurch gekennzeichnet, dass** die Klebeschicht (6) und der Transponderchip (2) auf derselben Seite relativ zur Isolierschicht (1) angeordnet sind.

12. System nach einem der Ansprüche 9 bis 11, **dadurch gekennzeichnet, dass** die Klebeschicht (6) durch eine abziehbare Abdeckfolie (14) abgedeckt ist.

13. System nach einem der Ansprüche 1 bis 12, **dadurch gekennzeichnet, dass** die Eingangsimpedanz des Transponders an die Eingangsimpedanz des Transponderchips (2) angepasst ist durch geeignete Wahl der geometrischen Lage (g, h) eines Anschlusspunktes des Transponderchips (2) an der die Antennenfunktion übernehmenden Metallfläche (3 bzw. 4).

14. System nach einem der vorhergehenden Ansprüche, **dadurch gekennzeichnet, dass** der Transponderchip (2) zwischen der Isolierschicht (1) und dem metallischen Bestandteil (7) des Gegenstands liegt.

15. System nach einem der vorhergehenden Ansprüche, **dadurch gekennzeichnet, dass** der Transponder auf einer leitfähigen Oberfläche des metallischen Bestandteils (7) appliziert ist.

16. System nach Anspruch 15, **dadurch gekennzeichnet, dass** der Transponder mittels einer leitfähigen Klebeschicht (6) auf der leitfähigen Oberfläche des metallischen Bestandteils (7) appliziert ist.

17. System nach einem der Ansprüche 1 bis 16, **dadurch gekennzeichnet, dass** der Transponder gemeinsam mit dem metallischen Bestandteil (7) mit einer Lackschicht (8) überlackiert ist.

18. System nach einem der Ansprüche 1 bis 17, **da-**

**durch gekennzeichnet, dass** das System für eine bestimmte Arbeitsfrequenz ausgelegt ist, zumindest die erste Metallfläche (3) viereckig ausgebildet ist und eine erste Seitenlänge der ersten Metallfläche (3) der halben Wellenlänge ($\lambda$/2) der Arbeitsfrequenz entspricht und eine zweite Seitenlänge der ersten Metallfläche (3) größer oder kleiner der halben Wellenlänge der Arbeitsfrequenz ist.

19. Verfahren zur Herstellung einer Transpondervorrichtung für eine Patch-Antenne, umfassend die Schritte:

a) zur Verfügung Stellen einer flexiblen, elektrisch isolierenden Folie (1),
b) beidseitiges Beschichten der Folie (1) mit einer ersten Metallfläche (3) mit einer ersten Randkontur und einer zweiten Metallfläche (4) mit einer zweiten Randkontur,
c) Erzeugen einer Aussparung (5) in einer der beiden Metallflächen (3 bzw. 4),
d) Erzeugen eines Durchkontaktierungslochs (12) durch die Folie (1) hindurch im Bereich der Aussparung (5),
e) Auffüllen des Durchkontaktierungslochs (12) mit einer leitfähigen Substanz,
f) Applizieren eines Chips (2) im Bereich der Aussparung (5) derart, dass der Chip auf einer Seite der Folie (1) mit der dort vorliegenden einen der beiden Metallflächen (3 bzw. 4) elektrisch verbunden ist und über das Durchkontaktierungsloch (12) elektrisch mit der auf der anderen Seite der Folie (1) vorliegenden anderen der beiden Metallflächen (4 bzw. 3) verbunden ist, und
g) Aufbringen einer Kleberschicht (6), die einen leitfähigen Kleber umfasst, auf die zweite Metallfläche (4) zur Verklebung mit ein metallischen Oberfläche eines Gegenstandes.

wobei zumindest die erste Metallfläche (3) geometrisch so ausgebildet wird, dass sie in einer Patch-Antenne Antennenfunktion übernehmen kann und eine durch die Randkontur der ersten Metallfläche (3) definierte Fläche größer einer durch die Randkontur der zweiten Metallfläche (4) definierten Fläche ist.

20. Verfahren nach Anspruch 19, **dadurch gekennzeichnet, dass** das Beschichten der Metallflächen (3, 4) in einem Aufdampfprozeß und die Aussparung (5) in einem anschließenden Ätzprozeß erfolgen.

21. Verfahren nach Anspruch 20, **dadurch gekennzeichnet, dass** das Beschichten mit zumindest einer der beiden Metallflächen (3, 4) durch Auflaminieren einer Metallfolie erfolgt und die Aussparung (5) zuvor in der Metallfolie erzeugt wird.

22. Verfahren nach Anspruch 21, **dadurch gekennzeichnet, dass** in der Aussparung (5) mittels leitfähiger Druckfarbe mindestens ein Kontaktbereich (10, 11) in einem Druckprozeß erzeugt wird.

23. Verfahren nach einem der Ansprüche 19 bis 22, **dadurch gekennzeichnet, dass** im Bereich der Aussparung (5) eine Vertiefung für den Chip (2) in einem Prägeprozeß erzeugt wird.

**Claims**

1. A system comprising a transponder with a patch antenna (1, 3, 4) and an object possessing at least one metallic component (7),
the transponder comprising

- a first metal surface (3) with a first edge contour,
- a second metal surface (4) with a second edge contour,
- an insulating layer (1) disposed between the first metal surface (3) and the second metal surface (4) for electrically insulating the first metal surface (3) from the second metal surface (4), and
- a transponder chip (2) which is electrically connected to the first metal surface (3),

wherein the first metal surface (3) is configured geometrically so that it can perform an antenna function in the radio-frequency range for the patch antenna, **characterized in that**
the surface defined by the second edge contour of the second metal surface (4) is smaller than the surface defined by the first edge contour of the first metal surface (3),
the transponder chip (2) is electrically connected to the second metal surface (4), the second metal surface (4) is galvanically coupled to the metallic component (7) of the object, and
the metallic component (7) possesses such a superficial extent, and the transponder is so disposed relative to the metallic component (7) of the object, that the metallic component (7) acts as a ground plane of the patch antenna.

2. The system according to claim 1, **characterized in that** the transponder chip (2) is galvanically connected to the first metal surface (3) and the second metal surface (4), in particular by flip chip technology.

3. The system according to either of claims 1 and 2, **characterized by** a feed-through (12) through the insulating layer (1) for contacting the transponder chip (2) with the first or second metal surface (3, 4) located on the side of the transponder opposite the transponder chip (2).

4. The system according to any of claims 1 to 3, **characterized in that** the transponder chip (2) is disposed in a depression in the insulating layer (1).

5. The system according to any of claims 1 to 4, **characterized in that** the transponder chip (2) is covered by means of a separate protective layer (9).

6. The system according to claim 5, **characterized in that** the transponder chip (2) is covered by means of a potting compound.

7. The system according to claim 5 or 6, **characterized in that** the transponder chip (2) is covered by a protective film (9) which extends over the total surface of the transponder.

8. The system according to any of claims 1 to 7, **characterized in that** the insulating layer (1) is constituted by a plastic film, in particular of PET and/or with a thickness of 100 $\mu$m.

9. The system according to any of claims 1 to 8, **characterized by** an adhesive layer (6) for application of the transponder to an object.

10. The system according to claim 9, **characterized in that** the adhesive layer (6) comprises a conductive adhesive.

11. The system according to claim 9 or 10, **characterized in that** the adhesive layer (6) and the transponder chip (2) are disposed on the same side relative to the insulating layer (1).

12. The system according to any of claims 9 to 11, **characterized in that** the adhesive layer (6) is covered by a removable cover film (14).

13. The system according to any of claims 1 to 12, **characterized in that** the input impedance of the transponder is adapted to the input impedance of the transponder chip (2) by a suitable choice of the geometric position (g, h) of a connection point of the transponder chip (2) on the metal surface (3 or 4) performing the antenna function.

14. The system according to any of the previous claims, **characterized in that** the transponder chip (2) is located between the insulating layer (1) and the metallic component (7) of the object.

15. The system according to any of the previous claims, **characterized in that** the transponder is applied to a conductive surface of the metallic component (7).

16. The system according to claim 15, **characterized in that** the transponder is applied to the conductive surface of the metallic component (7) by means of a conductive adhesive layer (6).

17. The system according to any of claims 1 to 16, **characterized in that** the transponder, together with the metallic component (7), is lacquered over with a lacquer layer (8).

18. The system according to any of claims 1 to 17, **characterized in that** the system is designed for a certain working frequency, at least the first metal surface (3) is configured to be quadrangular, and a first side length of the first metal surface (3) corresponds to half the wavelength ($\lambda$2) of the working frequency, and a second side length of the first metal surface (3) is greater or smaller than half the wavelength of the working frequency.

19. A method for producing a transponder apparatus for a patch antenna, comprising the steps of:

   a) providing a flexible, electrically insulating film (1),
   b) coating both sides of the film (1) with a first metal surface (3) with a first edge contour and a second metal surface (4) with a second edge contour,
   c) producing a gap (5) in one of the two metal surfaces (3 or 4),
   d) producing a feed-through hole (12) through the film (1) in the area of the gap (5),
   e) filling the feed-through hole (12) with a conductive substance,
   f) applying a chip (2) in the area of the gap (5) such that the chip is electrically connected on one side of the film (1) to the one of the two metal surfaces (3 or 4) present there, and is connected via the feed-through hole (12) electrically to the other of the two metal surfaces (4 or 3) present on the other side of the film (1), and
   g) applying an adhesive layer (6) comprising a conductive adhesive to the second metal surface (4) for adhesion to a metallic surface of an object,

   wherein at least the first metal surface (3) is configured geometrically so that it can perform an antenna function in a patch antenna, and a surface defined by the edge contour of the first metal surface (3) is greater than a surface defined by the edge contour of the second metal surface (4).

20. The method according to claim 19, **characterized in that** the coating of the metal surfaces (3, 4) is effected by a vapor deposition process, and the gap (5) by a subsequent etching process.

21. The method according to claim 20, **characterized**

**in that** the coating with at least one of the two metal surfaces (3, 4) is effected by laminating a metal film, and the gap (5) is previously produced in the metal film.

22. The method according to claim 21, **characterized in that** at least one contact area (10, 11) is produced in the gap (5) by a printing process by means of conductive printing ink.

23. The method according to any of claims 19 to 22, **characterized in that** a depression for the chip (2) is produced by an embossing process in the area of the gap (5).

## Revendications

1. Système comprenant un transpondeur pourvu d'une antenne microruban (1, 3, 4) et d'un objet qui possède au moins un composant métallique (7), le transpondeur comprend

   - une première surface métallique (3) ayant un premier contour marginal
   - une deuxième surface métallique (4) ayant un deuxième contour marginal
   - une couche isolante (1) placée entre la première surface métallique (3) et la deuxième surface métallique (4) pour l'isolation électrique de la première surface métallique (3) par rapport à la deuxième surface métallique (4), et
   - une puce de transpondeur (2) qui est reliée électriquement à la première surface métallique (3),

   la première surface métallique (3) étant façonnée géométriquement de telle sorte qu'elle peut assumer pour l'antenne microruban une fonction d'antenne dans le domaine de la gamme radiofréquence, **caractérisé en ce que**
   la surface définie par le deuxième contour marginal de la deuxième surface métallique (4) est plus petite que la surface définie par le premier contour marginal de la première surface métallique (3),
   la puce du transpondeur (2) est reliée électriquement à la deuxième surface métallique (4),
   la deuxième surface métallique (4) est couplée galvaniquement au composant métallique (7) de l'objet et
   le composant métallique (7) possède une étendue telle et le transpondeur est placé de telle manière par rapport au composant métallique (7) de l'objet que le composant métallique (7) agit en tant que plan de masse de l'antenne microruban.

2. Système selon la revendication 1, **caractérisé en ce que** la puce du transpondeur (2) est reliée galvaniquement à la première surface métallique (3) et à la deuxième surface métallique (4), notamment au moyen de la technologie puce retournée.

3. Système selon l'une des revendications 1 ou 2, **caractérisé par** un trou de contact (12) pratiqué à travers la couche isolante (1) pour la mise en contact de la puce du transpondeur (2) avec la première ou respectivement la deuxième surface métallique (3, 4) située du côté du transpondeur opposé par rapport à la puce du transpondeur (2).

4. Système selon l'une des revendications de 1 à 3, **caractérisé en ce que** la puce du transpondeur (2) est placée dans un renfoncement de la couche isolante (1).

5. Système selon l'une des revendications de 1 à 4, **caractérisé en ce que** la puce du transpondeur (2) est recouverte au moyen d'une couche protectrice (9) distincte.

6. Système selon la revendication 5, **caractérisé en ce que** la puce du transpondeur (2) est recouverte au moyen d'une masse de scellement.

7. Système selon l'une des revendications de 5 à 6, **caractérisé en ce que** la puce du transpondeur (2) est recouverte d'un film de protection (9) qui s'étend sur toute la surface du transpondeur.

8. Système selon l'une des revendications de 1 à 7, **caractérisé en ce que** la couche isolante (1) est constituée d'un film plastique, notamment en PET et / ou d'une épaisseur de 100 $\mu$m.

9. Système selon l'une des revendications de 1 à 8, **caractérisé par** une couche adhésive (6) destinée à l'application du transpondeur sur un objet.

10. Système selon la revendication 9, **caractérisé en ce que** la couche adhésive (6) comprend un adhésif conductible.

11. Système selon l'une des revendications de 9 à 10, **caractérisé en ce que** la couche adhésive (6) et la puce du transpondeur (2) sont placées du même côté par rapport à la couche isolante (1).

12. Système selon l'une des revendications de 9 à 11, **caractérisé en ce que** la couche adhésive (6) est recouverte par un film de recouvrement (14) pouvant être retiré.

13. Système selon l'une des revendications de 1 à 12, **caractérisé en ce que** l'impédance d'entrée du transpondeur est adaptée à l'impédance d'entrée de la puce du transpondeur (2) par un choix approprié de la position géométrique (g, h) d'un point de connexion de la puce du transpondeur (2) à la surface métallique (3 ou respectivement 4) assumant la fonction d'antenne.

14. Système selon l'une des revendications précédentes, **caractérisé en ce que** la puce du transpondeur (2) est située entre la couche isolante (1) et le composant métallique (7) de l'objet.

15. Système selon l'une des revendications précédentes, **caractérisé en ce que** le transpondeur est appliqué sur une surface conductible du composant métallique (7).

16. Système selon la revendication 15, **caractérisé en ce que** le transpondeur est appliqué sur la surface conductible du composant métallique (7) au moyen d'une couche adhésive (6) conductible.

17. Système selon l'une des revendications de 1 à 16, **caractérisé en ce que** le transpondeur et le composant métallique (7) sont conjointement recouverts d'une couche de vernis (8).

18. Système selon l'une des revendications de 1 à 17, **caractérisé en ce que** le système est conçu pour une fréquence de fonctionnement déterminée, au moins la première surface métallique (3) étant façonnée de manière quadrangulaire et une première longueur de côté de la première surface métallique (3) correspondant à la demi-longueur d'onde ($\lambda$/2) de la fréquence de fonctionnement et une deuxième longueur de côté de la première surface métallique (3) étant plus grande ou plus petite que la demi-longueur d'onde de la fréquence de fonctionnement.

19. Procédé de fabrication d'un dispositif de transpondeur pour une l'antenne microruban comprenant trois étapes :

a) mise à disposition d'un film (1) flexible électriquement isolant,
b) application sur les deux côtés du film (1) d'une première surface métallique (3) ayant un premier contour marginal et d'une deuxième surface métallique (4) ayant un deuxième contour marginal,
c) création d'un évidement (5) dans une des deux surfaces métalliques (3 ou respectivement 4),
d) création d'un trou de contact (12) à travers le film (1) au niveau de l'évidement (5),
e) remplissage du trou de contact (12) avec une substance conductible,
f) application d'une puce (2) au niveau de l'évidement (5) de telle manière que la puce est électriquement reliée d'un côté du film (1) avec l'une des deux surfaces métalliques (3 ou respectivement 4) s'y trouvant et que la puce est, à travers le trou de contact (12), électriquement reliée à l'autre des deux surfaces métalliques (4 ou respectivement 3) se trouvant de l'autre côté du film (1), et
g) application d'une couche adhésive (6) comprenant un adhésif conductible sur la deuxième surface métallique (4) pour le collage avec une surface métallique d'un objet,

au moins la première surface métallique (3) étant façonnée géométriquement de telle sorte qu'elle peut assumer dans une antenne microruban une fonction d'antenne et qu'une surface définie par le contour marginal de la première surface métallique (3) est plus grande qu'une surface définie par le contour marginal de la deuxième surface métallique (4).

20. Procédé selon la revendication 19, **caractérisé en ce que** l'application des surfaces métalliques (3, 4) s'effectue lors d'un processus de métallisation et **en ce que** l'évidement (5) s'effectue ensuite lors d'un processus de gravure.

21. Procédé selon la revendication 20, **caractérisé en ce que** l'application d'au moins une des deux surfaces métalliques (3, 4) s'effectue par application par laminage d'un film métallique et **en ce que** l'évidement (5) est pratiqué auparavant dans le film métallique.

22. Procédé selon la revendication 21, **caractérisé en ce qu'**au moins une zone de contact (10,11) est pratiquée dans l'évidement (5) au moyen d'encre d'impression conductible lors d'un processus d'impression.

23. Procédé selon l'une des revendications de 19 à 22, **caractérisé en ce qu'**un renfoncement pour la puce (2) est pratiqué au niveau l'évidement (5) lors d'un processus d'estampage.

FIG 1

FIG 2

FIG 3

## FIG 4

## FIG 5

## FIG 6

## FIG 7

FIG 8

FIG 9

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 6121878 A
- US 6215402 B
- GB 2393076 A
- US 6329915 B1
- US 5552790 A
- US 6215401 B1

**In der Beschreibung aufgeführte Nicht-Patentliteratur**

- RFID-Handbuch. Carl Hanser Verlag